# EUROPÄISCHE PATENTSCHRIFT

(11) **EP 4 134 681 B1**
(45) Veröffentlichungstag und Bekanntmachung des Hinweises auf die Patenterteilung: **22.04.2026**
(21) Anmeldenummer: 22188068.5
(22) Anmeldetag: 01.08.2022
(51) Int. Cl.: G01R 15/20, G01R 19/00, G01R 19/10

(54) **STROMERFASSUNGSANORDNUNG**
CURRENT DETECTING DEVICE
DISPOSITIF DE DÉTECTION DU COURANT

(30) Priorität: 10.08.2021 DE 102021208720
(43) Veröffentlichungstag der Anmeldung: 15.02.2023
(73) Patentinhaber: Robert Bosch GmbH, 70442 Stuttgart (DE)
(72) Erfinder: Mehringer, Paul, 70569 Stuttgart (DE); Harsanyi, Balazs Bence, 74321 Bietigheim-Bissingen (DE)

(56) Entgegenhaltungen:
- EP-A1- 1 273 921
- EP-A1- 3 742 180
- WO-A1-2013/151792
- US-A- 5 694 103
- US-A1- 2015 177 339

## Beschreibung

### Stand der Technik

Die Erfindung betrifft eine Stromerfassungsanordnung. Die Stromerfassungsanordnung weist wenigstens eine elektrisch leitfähige Stromschiene auf. Die elektrisch leitfähige Stromschiene ist zum Führen eines Laststromes ausgebildet. In der Stromschiene ist ein Längsabschnitt zum Erfassen des in der Stromschiene fließenden Laststromes ausgebildet. Die Stromerfassungsanordnung weist auch wenigstens einen Stromsensor auf, welcher angeordnet und ausgebildet ist, ein auf dem Längsabschnitt erzeugtes Magnetfeld zu erfassen, und in Abhängigkeit des Magnetfelds ein den Laststrom repräsentierendes Stromsignal zu erzeugen.

Aus der DE 199 469 35 ist eine Vorrichtung zur Strommessung mit magnetfeldempfindlichen Differenzsensoren aus mindestens zwei Hall-Sensoren bekannt, wobei die Hall-Sensoren jeweils in einer Ausnehmung eines Leiterblechs angeordnet sind. Aus der EP1273921A1 ist ein weiterer Stromsensor bekannt. In einem Beispiel sind zwei Leiter mit Ausnehmungen übereinander angeordnet und sind dazu ausgebildet Strom in der gleichen Richtung zu führen. Die Ausnehmungen überlappen sich, und ein Hallsensor ist in dem Überlappungsbereich angeordnet. Ein ähnlicher Stromsensor mit zwei Leitern, die Schlaufen umfassen, ist aus der US5694103A bekannt. Die Schlaufen überlappen sich, jedoch sind die parallel zueinander verlaufenden Leiter nicht übereinander angeordnet. Die Leiter sind dazu ausgebildet Strom in entgegengesetzter Richtung zu führen.

### Offenbarung der Erfindung

Eine Stromerfassungsanordnung gemäß der Erfindung wird im unabhängigen Anspruch 1 definiert, vorteilhafte Ausführungsformen in den abhängigen Ansprüchen.

Erfindungsgemäß weist die Stromerfassungsanordnung der eingangs genannten Art eine weitere Stromschiene auf. Die weitere Stromschiene ist ausgebildet, einen Strom, insbesondere Gleichstrom, mit einer zu dem Laststrom entgegengesetzten Stromrichtung zu führen. Die zu der Stromschiene parallel verlaufende weitere Stromschiene ist im Bereich des Längsabschnitts zu der Stromschiene derart geführt, dass ein auf dem Längsabschnitt von der weiteren Stromschiene erzeugtes Magnetfeld, das Magnetfeld der Stromschiene feldverstärkend überlagern kann.

Vorteilhaft kann auf diese Weise eine besonders empfindliche Stromerfassungsanordnung gebildet sein. Es wurde nämlich erkannt, dass bei zueinander parallel geführten Stromschienen, insbesondere Gleichstromschienen, zur Ausbildung einer niederinduktiven Anordnung Magnetfelder einander kompensieren können. Ein Stromsensor, welcher ausgebildet ist, ein in der Stromschiene erzeugtes Magnetfeld zu erfassen, kann durch die so gebildete niederinduktive Eigenschaft beeinflusst werden. Es wurde nämlich erkannt, dass das von dem Stromsensor zu erfassende Magnetfeld auch von der weiteren Stromschiene geschwächt, oder gestört werden kann. Mit der feldverstärkenden Überlagerung der weiteren Stromschiene kann so vorteilhaft ein Hall-Signal, insbesondere Differenz-Hall-Signal, erzeugt werden, welches einen großen Signal-Rausch-Abstand aufweist.

Bevorzugt ist die weitere Stromschiene von der Stromschiene elektrisch isoliert. Dadurch kann vorteilhaft eine durchschlagfeste niederinduktive Anordnung gebildet sein.

Erfindungsgemäß ist die weitere Stromschiene ausgebildet, insbesondere mittels Feld- und/oder Störungskompensation, gemeinsam mit der Stromschiene eine niederinduktive Anordnung auszubilden. Vorteilhaft kann die Stromerfassung so nicht durch die niederinduktive Anordnung gestört werden.

In einer bevorzugten Ausführungsform ist die Stromschiene zum Führen eines positiven Stromversorgungspotentials ausgebildet, und die weitere Stromschiene zum Führen eines negativen Stromversorgungspotentials ausgebildet. Vorteilhaft kann so eine Gleichstromversorgungsanordnung gebildet sein, welche beispielsweise einen Inverter, oder eine Kommutierzelle für einen Inverter mit Gleichstrom versorgen kann.

In einer bevorzugten Ausführungsform der Stromerfassungsanordnung sind die Stromschiene und die weitere Stromschiene im Bereich des Längsabschnitts jeweils derart mäanderförmig zueinander geführt, dass in der Stromschiene und in der weiteren Stromschiene einander entgegengesetzt fließende Ströme auf dem Längsabschnitt jeweils mit wenigstens einer Richtungskomponente in die gleiche Richtung, oder vollständig in die gleiche Richtung fließen können. Vorteilhaft kann die in der weiteren Stromschiene entgegengesetzt gerichtete Stromrichtung mittels des Mäanders derart umgelenkt werden, dass auf dem Längsabschnitt die Stromrichtungen in der Stromschiene, und in der weiteren Stromschiene jeweils gleichgerichtet sind. Auf diese Weise können auf den Längsabschnitten der Stromschiene und der weiteren Stromschiene jeweils gleichgerichtet umlaufende Magnetfelder erzeugt werden, welche durch die Gleichrichtung des Umlaufs einander verstärken können. Der Stromsensor kann so das durch die gleichgerichteten Längsabschnitte verstärkte Magnetfeld erfassen, und ein das verstärkte Magnetfeld repräsentierende Ausgangssignal erzeugen, das den in der Stromschiene fließenden Strom repräsentiert.

In einer bevorzugten Ausführungsform sind die Stromschiene und die weitere Stromschiene auf dem Längsabschnitt jeweils zueinander gegensinnig S-förmig, oder zueinander symmetrisch, insbesondere achsensymmetrisch oder punktsymmetrisch S-förmig gebildet. Vorteilhaft kann so eine mehrfach mäanderförmig gewundene Stromschiene auf dem Längsabschnitt gebildet sein, welche durch die Windungen das Magnetfeld in den konkaven Bereichen der Windung durch Feldüberlagerung der auf dem Längsabschnitt der jeweiligen Stromschiene selbst gebildeten Magnetfelds verstärken kann. Zusätzlich dazu kann durch die Überlagerung der Magnetfelder auf dem Längsabschnitt der Stromschiene und der weiteren Stromschiene ein gut erfassbares Sensorsignal gebildet werden.

Bevorzugt ist durch die Mäanderform in der Stromschiene eine S-Form gebildet, und durch die Mäanderform in der weiteren Stromschiene eine zu der S-Form gegensinnige Form, insbesondere Fragezeichen-Form in der weiteren Stromschiene gebildet. Vorteilhaft kann die S-Form, und die Fragezeichen-Form aus der Stromschiene beispielsweise mittels Stanzen mit demselben Stanzwerkzeug erzeugt werden. Die Fragezeichen-Form in der weiteren Stromschiene kann so durch ein Wenden der weiteren Stromschiene um die Längsachse, und relative Parallelanordnung zu der Stromschiene ausgebildet werden.

In einer bevorzugten Ausführungsform der Stromerfassungsanordnung weist die Stromschiene und/oder die weitere Stromschiene im Bereich des Längsabschnitts einen Durchbruch auf. Der Stromsensor ist im Bereich des Durchbruchs derart angeordnet, dass der Stromsensor von den durchbruchumgebenden Stromschienenabschnitten, insbesondere Stegen, erzeugte Magnetfelder erfassen kann. Vorteilhaft kann der Stromsensor so ein von den Stegen erzeugtes Magnetfeld erfassen, welches mit einem von der weiteren Stromschiene, insbesondere negativen Stromschiene erzeugten Magnetfeld gleichsinnig umlaufend gerichtet ist. Vorteilhaft können die Magnetfelder der Stromschiene und der weiteren Stromschiene so feldverstärkend einander überlagern.

In einer bevorzugten Ausführungsform ist die weitere Stromschiene im Bereich des Längsabschnitts schmaler ausgebildet, als auf den den Längsabschnitt umgebenden Bereichen. Vorteilhaft brauchen die Stege die weitere Stromschiene so in einer Projektion auf die weitere Stromschiene nicht so weit seitlich, insbesondere quer zu einer Längserstreckung der weiteren Stromschiene, überragen.

In einer bevorzugten Ausführungsform ist die weitere Stromschiene im Bereich des Längsabschnitts mit dem gleichen Querschnitt oder der gleichen Breite gebildet, wie auf den den Längsabschnitt umgebenden Bereichen. Weiter bevorzugt sind die Stege der Stromschiene auf dem Längsabschnitt in ihrer breiten Summe im Vergleich zu einer Breite der Stromschiene außerhalb des Längsabschnitts, gleich breit ausgebildet. Vorteilhaft kann so eine Stromdichte im Bereich des Längsabschnitts im Vergleich zu den den Längsabschnitt umgebenden Abschnitten der Stromschiene gleich ausgebildet sein. So kann vorteilhaft im Bereich des Längsabschnitts kein Hot-Spot gebildet werden.

In einer bevorzugten Ausführungsform ist die weitere Stromschiene auf dem Längsabschnitt I-förmig gebildet, und bildet so ein Komplement zu der Aussparung der Stromschiene auf dem Längsabschnitt. Vorteilhaft können die Stromschienen so gemeinsame Durchbrüche zum Durchtritt der Magnetfeldlinien im Bereich des Stromsensors ausbilden.

Erfindungsgemäß sind die Stromschiene und die weitere Stromschiene im Bereich des Längsabschnitts jeweils zueinander parallel verlaufend angeordnet. Erfindungsgemäß weisen die Stromschiene und die weitere Stromschiene im Bereich des Längsabschnitts jeweils eine Aussparung auf, die in einer Orthogonalprojektion einander überlappend eine Öffnung zum Durchtritt eines gemeinsamen Magnetfelds ausbilden. Vorteilhaft kann so platzsparend eine Magnetfeldverstärkung ausgebildet sein. Der Hall-Sensor ist beispielsweise im Bereich der gemeinsam gebildeten Öffnung angeordnet. Der weitere Hall-Sensor des Stromsensors ist in diesem Ausführungsbeispiel zu den Stromschienen benachbart angeordnet, und kann wenigstens einen Teil der einander überlagernden Magnetfeldlinien erfassen.

In einer bevorzugten Ausführungsform sind die Stromschiene und die weitere Stromschiene auf dem Längsabschnitt jeweils U-förmig ausgebildet, wobei die U-Öffnungen in zueinander entgegengesetzte Richtungen weisen. Vorteilhaft kann so auf einfache Weise eine in einer Projektion der U-Öffnungen gebildete Durchtrittsöffnung für das gemeinsame Magnetfeld gebildet sein.

In einer bevorzugten Ausführungsform weist die Stromschiene und die weitere Stromschiene auf dem Längsabschnitt jeweils in zueinander entgegengesetzt weisende, quer zur Längserstreckung der Leiterbahn gebildete Aussparungen auf. Die Aussparungen bilden bevorzugt einander überdeckend einen gemeinsamen Durchbruch, durch den auf den Längsabschnitten jeweils gebildete Magnetfeldlinien durchtreten, und von dem Stromsensor erfasst werden können. Vorteilhaft kann so eine Anordnung gebildet sein, bei der die Stromschienen im Bereich des Längsabschnitts und in den den Längsabschnitt umgebenden Bereichen jeweils denselben Querschnitt, und insbesondere dieselbe Breite aufweisen.

In einer bevorzugten Ausführungsform sind die Stromschienen jeweils durch ein sich flach erstreckendes Rechteckprofil gebildet. Beispielsweise sind die Stromschienen jeweils durch ein Stanzgitter, auch Lead-Frame genannt, insbesondere Kupfer-Stanzgitter gebildet. Vorteilhaft können die Stromschienen so aufwandsgünstig bereitgestellt werden.

In einer anderen bevorzugten Ausführungsform umfasst die Stromerfassungsanordnung einen Schaltungsträger, wobei der Schaltungsträger eine elektrisch isolierende Schicht, insbesondere Keramikschicht, aufweist. Die Stromschienen sind in dieser Ausführungsform jeweils durch eine elektrisch leitfähige Schicht des Schaltungsträgers gebildet, wobei die elektrisch leitfähigen Schichten durch die elektrisch isolierende Schicht voneinander isoliert und getrennt sind. Vorteilhaft können die Stromschienen so aufwandsgünstig und durchschlagfest miteinander verbunden sein.

Der Stromsensor kann beispielsweise zu dem Schaltungsträger parallel angeordnet, oder auf einem weiteren Schaltungsträger angeordnet sein, welcher sich zu dem Schaltungsträger parallel erstreckt. Der weitere Schaltungsträger ist beispielsweise eine Leiterplatte, oder eine flexible Leiterplatte, ein LTCC-Schaltungsträger (LTCC = Low-Temperature-Cofired-Ceramics) oder ein HTCC-Schaltungsträger (HTCC = High-Temperature-Cofired-Ceramics).

Die elektrisch isolierende Schicht des Schaltungsträgers ist beispielsweise eine Keramikschicht, insbesondere Aluminiumoxid-Schicht, oder Siliziumnitrid-Schicht. Vorteilhaft kann der Schaltungsträger so eine gute Wärmeleitfähigkeit aufweisen.

Der Schaltungsträger ist bevorzugt zum wärmeleitenden Kontaktieren einer Wärmesenke ausgebildet, und weist bevorzugt eine elektrisch leitfähige Rückseitenschicht auf, welche zum Kontaktieren einer Wärmesenke ausgebildet ist. Die weitere Stromschiene bildet bevorzugt eine elektrisch leitfähige und wärmeleitfähige Rückseitenschicht des Schaltungsträgers. Vorteilhaft kann auch so die Stromerfassungsanordnung aufwandsgünstig gekühlt werden.

In einer bevorzugten Ausführungsform kann der Schaltungsträger zusätzlich zu der negativen Stromschiene weitere in der Schaltungsträgerebene der negativen Stromschiene geführte Metallschichten, insbesondere Kupferschichten aufweisen.

In einer bevorzugten Ausführungsform ist die Stromerfassungsanordnung Bestandteil eines Multilayer-Schaltungsträgers. Die Stromerfassungsanordnung kann beispielsweise als Zwischenschichtanordnung in dem Multilayer-Schaltungsträger ausgebildet sein. Der Multilayer-Schaltungsträger ist beispielsweise ein keramischer Schaltungsträger, beispielsweise HTCC- oder LTCC-Schaltungsträger, oder eine Multilayer-Leiterplatte.

Die Stromschienen sind bevorzugt jeweils aus Kupfer oder einer Kupferlegierung gebildet.

Die Erfindung betrifft auch eine elektrische Maschine mit einer Stromerfassungsanordnung der vorbeschriebenen Art. Die Stromerfassungsanordnung ist ausgebildet, einen Versorgungsstrom der Maschine und/oder einen Zwischenkreisstrom zu erfassen. Bevorzugt weist die Maschine zur Stromversorgung zwei zueinander parallel und niederinduktiv geführte Stromschienen auf, wobei der Stromsensor im Bereich der Stromschienen angeordnet und ausgebildet ist, den auf den Stromschienen fließenden Strom, insbesondere Gleichstrom zu erfassen und ein den erfassten Strom repräsentierendes Stromsignal zu erzeugen. Die Maschine weist auch eine Steuereinheit auf, welche ausgebildet ist, die Maschine in Abhängigkeit des Stromsignals und insbesondere so in Abhängigkeit erfassten Versorgungsstroms und/oder Zwischenkreisstroms anzusteuern. Vorteilhaft kann die Stromerfassung der Maschine so effizient und mit einem guten Signal-Rauschverhältnis in einer niederinduktiven Stromschienenanordnung der Maschine erfolgen.

Die Erfindung wird nun im Folgenden anhand von Figuren und weiteren Ausführungsbeispielen erläutert. Weitere vorteilhafte Ausführungsvarianten ergeben sich aus einer Kombination der in den Figuren und in den abhängigen Ansprüchen beschriebenen Merkmale.
Figur 1 zeigt ein Ausführungsbeispiel für eine Stromerfassungsanordnung, bei der eine negative und eine positive Stromschiene übereinander angeordnet sind, wobei die Stromschienen auf einem Längsabschnitt auf dem ein Stromsensor angeordnet ist jeweils U-förmig ausgebildet sind;
Figur 2 zeigt ein Ausführungsbeispiel für eine Stromerfassungsanordnung, bei der eine negative und eine positive Stromschiene übereinander angeordnet sind, wobei die Stromschienen auf einem Längsabschnitt auf dem ein Stromsensor angeordnet ist jeweils eine Ausnehmung aufweisen;
Figur 3 zeigt die in Figur 2 gezeigte Stromerfassungsanordnung in einer Schnittdarstellung;
Figur 4 zeigt ein Ausführungsbeispiel für eine Stromerfassungsanordnung, bei der eine negative und eine positive Stromschiene übereinander angeordnet sind, wobei die negative Stromschiene auf einem Längsabschnitt, auf dem ein Stromsensor angeordnet ist, zum Durchtritt von Magnetfeldlinien eine Einschnürung aufweist und die positive Stromschiene einen Durchbruch aufweist;
Figur 5 zeigt die in Figur 4 gezeigte Stromerfassungsanordnung in einer Schnittdarstellung;
Figur 6 zeigt ein Ausführungsbeispiel für eine Stromerfassungsanordnung, bei der eine negative und eine positive Stromschiene übereinander angeordnet sind, wobei die Stromschienen auf einem Längsabschnitt auf dem ein Stromsensor angeordnet ist jeweils zueinander entgegengesetzt S-förmig ausgebildet sind;
Figur 7 zeigt ein Ausführungsbeispiel für eine Stromerfassungsanordnung, bei der eine negative und eine positive Stromschiene übereinander angeordnet sind, wobei die Stromschienen auf einem Längsabschnitt auf dem ein Stromsensor angeordnet ist jeweils zueinander entgegengesetzt S-förmig ausgebildet sind und wobei in den Stromschienen auf dem Längsabschnitt der Stromerfassung ein Durchbruch gebildet ist, in dem ein Stromsensor angeordnet ist;
Figur 8 zeigt eine Variante zu der in Figur 7 gezeigten Stromerfassungsanordnung in einer Schnittdarstellung, bei der die Stromschienen jeweils Bestandteil eines Schaltungsträgers sind und durch eine elektrisch isolierende Schicht des Schaltungsträgers voneinander getrennt sind;
Figur 9 zeigt ein Ausführungsbeispiel für eine elektrische Maschine mit wenigstens einer Stromerfassungsanordnung.

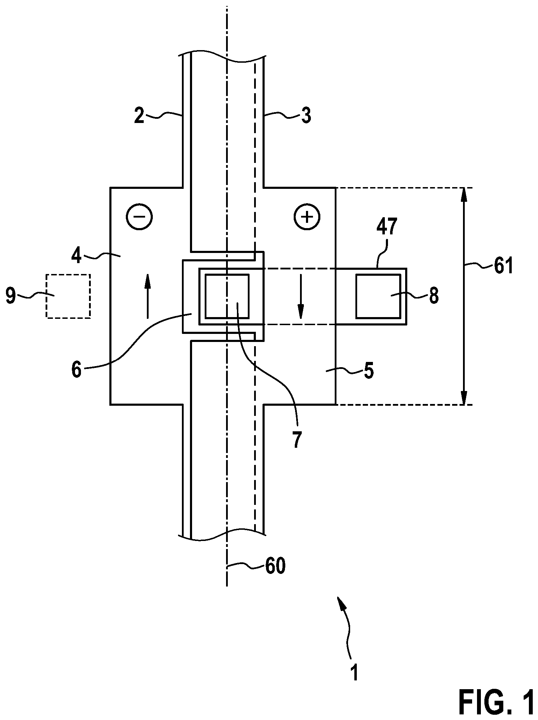

Figur 1 zeigt - schematisch - ein Ausführungsbeispiel für eine Stromerfassungsanordnung 1 in einer Aufsicht. Die Stromerfassungsanordnung 1 weist eine negative Stromschiene 2, und eine positive Stromschiene 3 auf. Die Stromschienen 2 und 3 sind in diesem Ausführungsbeispiel als Flachleiter ausgebildet. Die Flachleiter weisen jeweils einen rechteckigen Querschnitt auf, und können jeweils durch ein Stanzgitter, auch Lead-Frame genannt, oder durch eine elektrisch leitfähige Schicht eines Schaltungsträgers gebildet sein. Der Schaltungsträger ist beispielsweise ein keramischer Schaltungsträger, umfassend eine elektrisch isolierende Keramikschicht, und wenigstens zwei elektrisch leitfähige Schichten, welche jeweils auf zueinander entgegengesetzten Seiten der elektrisch isolierenden Keramikschicht ausgebildet sind, und die elektrisch isolierende Schicht zwischeneinander einschließen.

Die negative Stromschiene 2 und die positive Stromschiene 3 sind jeweils längsgestreckt ausgebildet und entlang einer Längserstreckung 60 derart übereinanderliegend angeordnet, dass die negative Stromschiene 2, und die positive Stromschiene 3 eine niederinduktive Anordnung ausbilden können.

Auf einem Längsabschnitt 61 entlang der Längserstreckung 60 ist in der negativen Stromschiene 2 eine U-förmige Mäanderschleife 4 ausgebildet. Auf dem Längsabschnitt 61 ist in der positiven Stromschiene 3 ebenfalls ein U-förmiger Mäander 5 ausgebildet. Die U-förmigen Mäander 4 und 5 sind mit den U-förmigen Mäandern jeweils derart übereinanderliegend angeordnet, dass ein durch die U-förmigen Mäander gemeinsam umschlossener Durchbruch 6 gebildet ist. Ein von den Mäandern 4 und 5 jeweils erzeugtes Magnetfeld, insbesondere von einem in den Stromschienen 2 und 3 fließendes Gleichstrom-Magnetfeld, kann so den gemeinsamen Durchbruch 6 durchdringen. Die Stromschienen 2 und 3 weisen auch im Bereich der Mäander 4 und 5 denselben Querschnitt, insbesondere dieselbe Querschnittsfläche auf, sodass im Bereich der Stromerfassung auf dem Längsabschnitt 61 kein Hot-Spot gebildet werden kann. Die Feldlinien des von den Stromschienen 2 und 3 jeweils erzeugten Magnetfeldes verlaufen so in dem Durchbruch 6 jeweils in die gleiche Richtung, sodass die Magnetfelder, erzeugt durch die negative Stromschiene 2, und die positive Stromschiene 3, jeweils einander verstärkend überlagern können.

In dem Durchbruch 6 ist ein Stromsensor 7, insbesondere Hall-Stromsensor, angeordnet, welcher gemeinsam mit einem weiteren Hall-Sensor 8 das Magnetfeld erfassen kann. Auf diese Weise kann durch die Hall-Sensoren 7 und 8 ein differenzieller Stromsensor 47 gebildet sein.

Figur 1 zeigt auch gestrichelt dargestellt einen weiteren Hall-Sensor 9, welcher Bestandteil des Stromsensors 47 sein kann. Der Stromsensor 47 kann in diesem Ausführungsbeispiel zwei, oder drei Hall-Sensoren zur Erfassung des von den Stromschienen 2 und 3 erzeugten Magnetfeldes aufweisen.

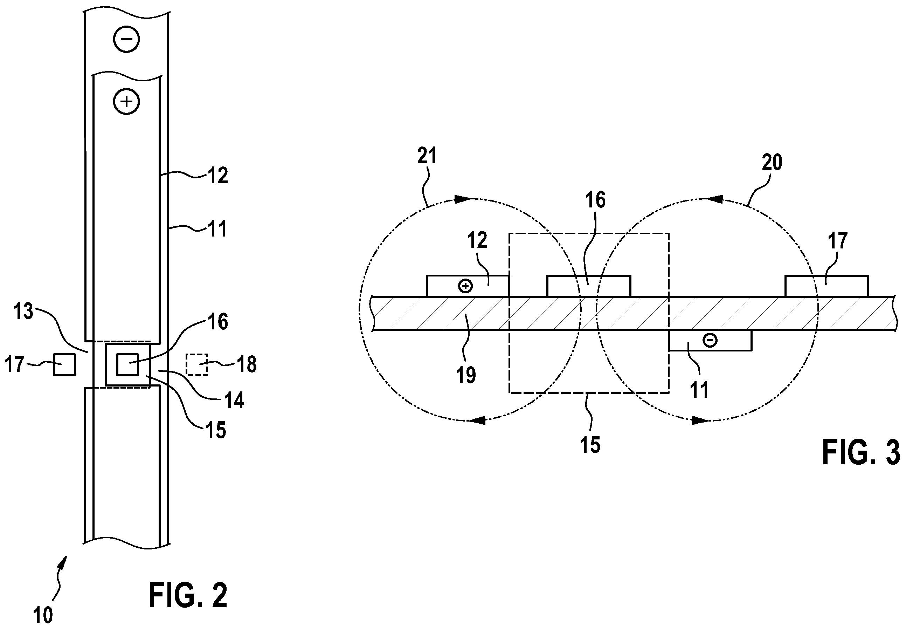

Figur 2 zeigt eine Stromerfassungsanordnung 10, welche eine negative Stromschiene 11, und eine positive Stromschiene 12 umfasst. Die negative Stromschiene 11 und die positive Stromschiene 12 sind entlang ihrer Längserstreckung jeweils derart übereinanderliegend angeordnet, dass durch die Stromschienen 11 und 12 eine niederinduktive Anordnung gebildet sein kann. Die negative Stromschiene 11 weist eine quer zu ihrer Längserstreckung gebildete Ausnehmung 13 auf, und die positive Stromschiene 12 weist eine quer zu ihrer Längserstreckung gebildete Ausnehmung 14 auf. Die Ausnehmungen 13 und 14 weisen jeweils derartig in zueinander entgegengesetzte Richtungen, dass in einem Überlappungsbereich der Ausnehmungen 13 und 14 ein durch die Stromschienen 11 und 12 gemeinsam gebildeter Durchbruch 15 gebildet ist. In dem Durchbruch 15 ist in diesem Ausführungsbeispiel ein Hall-Stromsensor 16 angeordnet, welcher Bestandteil eines Stromsensors sein kann, welcher aus dem Hall-Sensor 16, und einem weiteren Hall-Sensor 17 gebildet sein kann. Die Hall-Sensoren 16 und 17 sind so jeweils als differenzieller Hall-Sensor ausgebildet. Figur 2 zeigt - gestrichelt dargestellt - auch einen weiteren Hall-Sensor 18, welcher Bestandteil des bereits erwähnten Stromsensors sein kann. Der Stromsensor kann so zwei, oder drei Hall-Sensoren umfassen.

Figur 3 zeigt die in Figur 2 bereits in einer Aufsicht dargestellte Stromerfassungsanordnung in einer Schnittdarstellung. Die Stromerfassungsanordnung 10 umfasst einen Schaltungsträger, welcher eine elektrisch isolierende Schicht 19, insbesondere Keramikschicht, aufweisen kann. Die Keramikschicht ist beispielsweise eine Aluminiumoxid-Schicht, oder eine Siliziumnitrid-Schicht.

Die positive Stromschiene 12 kann auf dem in Figur 2 gezeigten Längsabschnitt, auf dem die Aussparungen 13 und 14 einander überlagern, ein Magnetfeld 21 ausbilden, und die negative Stromschiene 11 ein Magnetfeld 20. Die Magnetfelder 20 und 21 verlaufen in dem Durchbruch 15 jeweils in dieselbe Richtung, sodass der Hall-Sensor 16 ein aus den Magnetfeldern 20 und 21 überlagertes, verstärktes Magnetfeld erfassen kann.

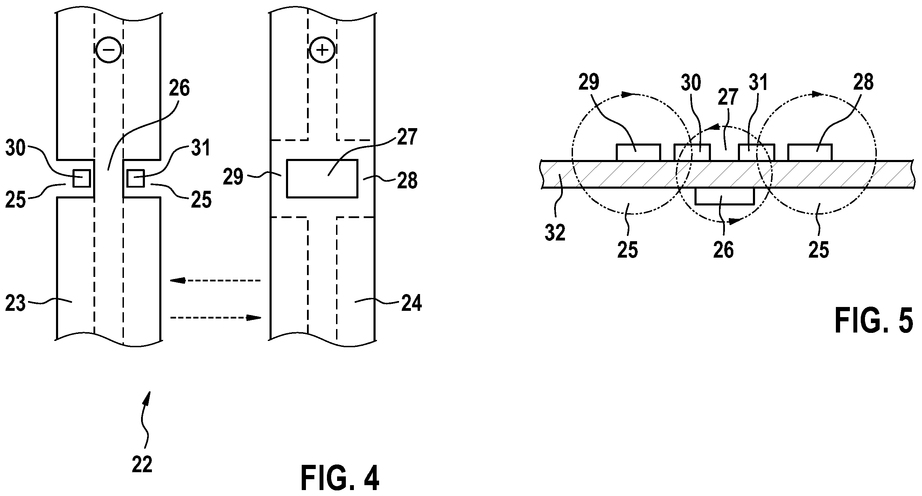

Figur 4 zeigt ein Ausführungsbeispiel für eine Stromerfassungsanordnung zum Erfassen eines Gleichstromes, welcher auf Stromschienen einer niederinduktiven Anordnung fließt. Die Stromerfassungsanordnung 22 umfasst eine negative Stromschiene 23, und eine positive Stromschiene 24, welche entlang ihrer Längserstreckung jeweils übereinanderliegend angeordnet sind. Die Stromschienen 23 und 24 können jeweils Bestandteil eines Schaltungsträgers, insbesondere keramischen Schaltungsträgers, sein.

Die negative Stromschiene 23 weist auf einem Längsabschnitt eine Einschnürung 25 auf, wobei die Einschnürung 25 einen Steg 26 umschließt. Ein Leiterquerschnitt der Stromschiene 23 ist durch die Einschnürung 25 im Bereich des Stegs 26 im Vergleich zu den umgebenden Längsabschnitten der Stromschiene 23, reduziert.

Die positive Stromschiene 24 weist auf dem Längsabschnitt einen Durchbruch auf, welcher mit der Einschnürung 25 derart überlagern kann, dass zwei Durchbrüche mittels der einander überlagerten Stromschienen 23 und 24 gebildet sind. In den Durchbrüchen ist jeweils ein Hall-Sensor 30 beziehungsweise 31 angeordnet, sodass ein um den Steg 26 der negativen Stromschiene gebildetes Magnetfeld, und die Magnetfelder der den Durchbruch 27 flankierenden Stege 28 und 29 der positiven Stromschiene 24, einander verstärkend überlagern können.

Figur 4 zeigt auch gestrichelt dargestellt eine Variante zu der Stromerfassungsanordnung, bei der die Stromschiene 23 keine Einschnürung aufweist, und die positive Stromschiene in Bereich des Stromsensors, gebildet durch die Hallsensoren 30 und 31, Ringförmig oder O-förmig ausgebildet ist, so dass Magnetfeldlinien durch den Durchbruch treten können. Die Stromschienen weisen bei der gestrichelt dargestellten Variante jeweils entlang der Längserstreckung im Bereich des Stromsensors denselben Leitungsquerschnitt oder einen größeren Leitungsquerschnitt auf, so dass im Bereich der Stromerfassung durch die Hallsensoren 30 und 31 kein thermischer Hot-Spot durch einen dort erhöhten ohmschen Widerstand gebildet werden kann.

Figur 5 zeigt die in Figur 4 gezeigte Stromerfassungsanordnung in einer Schnittdarstellung. Die Stromerfassungsanordnung 22 umfasst auch einen Schaltungsträger mit einer elektrisch isolierenden Schicht 32. Die Stromschienen 23 und 24 bilden jeweils eine elektrisch leitfähige Schicht, welche die elektrisch isolierende Schicht 32 zwischeneinander einschließen.

Die von der positiven Stromschiene 24 im Bereich des Durchbruchs 27, insbesondere von den positiven Stegen 28 und 29 erzeugten Magnetfelder, können im Bereich des Durchbruchs 27 mit dem Magnetfeld, erzeugt durch den Steg 26 der negativen Stromschiene 23 derart positiv überlagern, dass von den Stromsensoren 30 und 31 im Bereich des Durchbruchs 27 ein aus den positiven und negativen Magnetfeldern überlagertes verstärktes Magnetfeld erfasst werden kann.

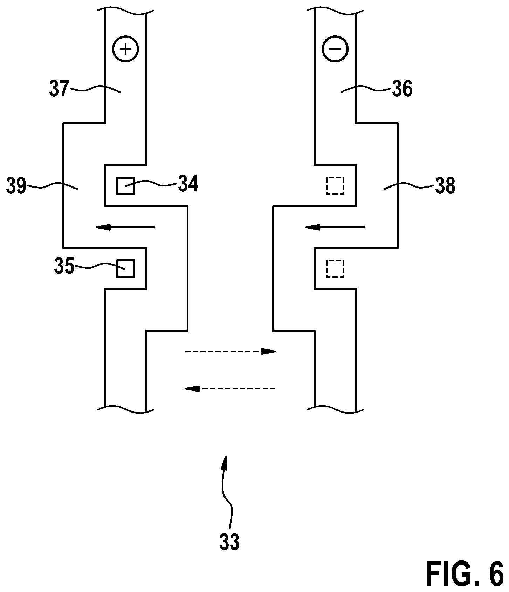

Figur 6 zeigt ein Ausführungsbeispiel für eine Stromerfassungsanordnung 33. Die Stromerfassungsanordnung 33 umfasst eine negative Stromschiene 36 und eine positive Stromschiene 37, welche entlang ihrer Längserstreckung derart übereinanderliegend angeordnet sind, dass aus den Stromschienen 36 und 37 eine niederinduktive Anordnung gebildet ist.

Die negative Stromschiene 36 weist eine S-förmige Mäanderschleife 38 auf, welche mit einer in der positiven Stromschiene 37 gebildeten, dazu entgegengesetzt gewundenen S-förmigen Mäanderschleife 39 derart überlagert ist, dass ein auf einem Längsabschnitt der Mäanderschleifen 38 und 39 - durch Pfeile gekennzeichnet - fließender negativer beziehungsweise positiver Strom jeweils in die gleiche Richtung fließt, und so die von den positiven beziehungsweise negativen Strömen erzeugten Magnetfelder einander feldverstärkend überlagern können.

In den Aussparungen der S-förmigen Mäander, welche jeweils zwei U-förmige Mäanderschleifen aneinandergereiht aufweisen, sind jeweils ein Hall-Stromsensor 34 und ein Hall-Stromsensor 35 angeordnet, welche jeweils Bestandteil eines differenziell erfassenden Stromsensors sein können.

Die S-Mäanderform 38 der negativen Stromschiene 36 bildet in diesem Ausführungsbeispiel in der in Figur 6 dargestellten geteilten Aufsicht im Vergleich zu der S-Mäanderform 39 der positiven Stromschiene 37 ein Fragezeichen, insoweit die S-Formen zueinander entgegengesetzt gewunden sind. Die Mäander 38 und 39 können in der Stromschiene 36 beziehungsweise 37 jeweils durch Stanzen gebildet sein, oder - im Falle eines Schaltungsträgers - durch Ätzen oder Laserablation gebildet sein.

Im Falle der gestanzten Stromschienen kann die Fragezeichen-Form der negativen Stromschiene 36 durch ein einfaches Wenden, und so eine Rotation um die Längsachse der Stromschiene 36 gebildet sein, sodass bei einem Übereinanderlegen der Stromschienen 36 und 37 die zueinander entgegengesetzte Mäanderform, insbesondere S-Form, und Fragezeichen-Form gebildet ist.

Die Stromschienen 36 und 37 sind in diesem Ausführungsbeispiel als Flachleiter mit insbesondere rechteckförmigem Querschnitt gebildet.

Die Stromschienen 36 und 37 der Stromerfassungsanordnung 33 gemäß Figur 6 weisen in diesem Ausführungsbeispiel entlang der Längserstreckung sowohl auf den Längsabschnitten, die übereinanderliegen, als auch auf den mäanderförmigen Längsabschnitten der S-förmigen Mäanderschleifen 38 beziehungsweise 39 jeweils denselben Leitungsquerschnitt auf. Vorteilhaft kann so kein Hot-Spot im Bereich der S-förmigen Mäanderschleifen 38 und 39 zur Stromerfassung mittels der Hall-Sensoren 34 und 35 gebildet sein.

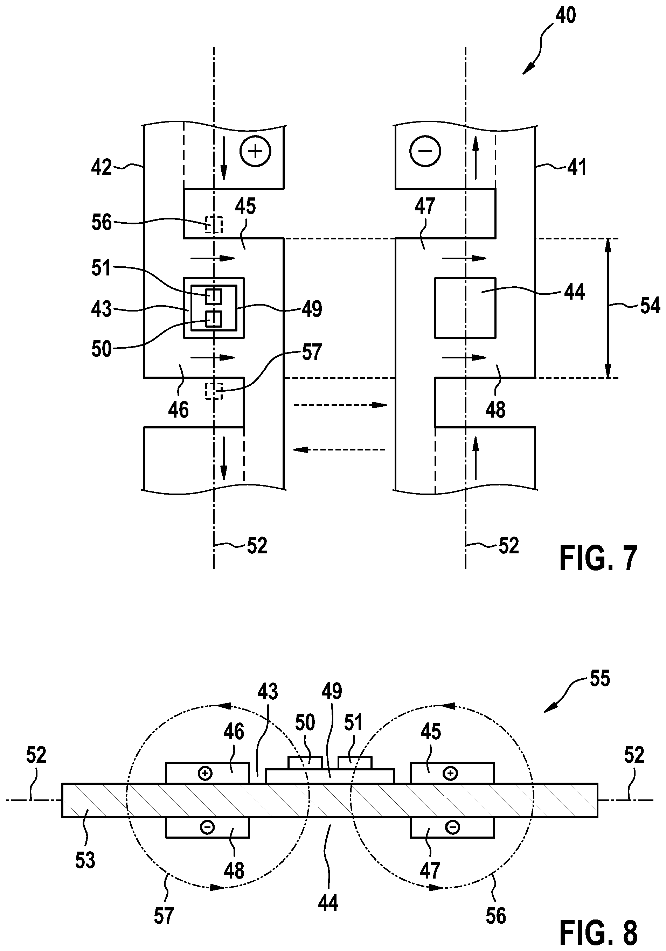

Figur 7 zeigt ein Ausführungsbeispiel für eine Stromerfassungsanordnung 40. Die Stromerfassungsanordnung 40 weist eine positive Stromschiene 42 und eine negative Stromschiene 41 auf, welche - wie durch gestrichelte Pfeile dargestellt - übereinander und zueinander parallel angeordnet sein können. Die positive Stromschiene 42 weist eine mäanderförmige S-Schleife auf, und die negative Stromschiene 41 eine dazu entgegengesetzt gewundene S-förmige Mäanderschleife, welche übereinanderliegend auf einem Längsabschnitt 54 den Stromfluss in den Stromschienen jeweils - insbesondere wie durch die Stromflusspfeile gekennzeichnet - auf dem Längsabschnitt in dieselbe Richtung quer zu einer gemeinsamen Längserstreckung 52 der Stromschienen 41 und 42 fließen.

Anders als in Figur 6, weisen die Stromschienen auf dem Längsabschnitt einen Durchbruch auf, der von zwei Stegen eingeschlossen ist, auf die der in den Stromschienen jeweils fließende Strom aufgeteilt werden kann. Die zueinander parallel geführten Stege der Stromschiene bilden gemeinsam einen Stromschienenabschnitt der Stromschiene.

Die positive Stromschiene 42 weist dazu auf dem Längsabschnitt 54 einen Durchbruch 43 auf, der zwischen zwei Stegen 45 beziehungsweise 46 eingeschlossen ist. Die negative Stromschiene 41 weist einen Durchbruch 44 auf, der von zwei Stegen 47 und 48 eingeschlossen ist. In dem Durchbruch oder im Bereich der Durchbrüche, ist in diesem Ausführungsbeispiel ein Stromsensor 49 angeordnet, welcher ausgebildet ist, ein von den Stegen erzeugtes Magnetfeld zu erfassen. Der Steg 45 der positiven Stromschiene 42 liegt dabei über dem Steg 47 der negativen Stromschiene 41, und der Steg 46 der positiven Stromschiene 42 liegt über dem Steg 48 der negativen Stromschiene 41, so dass die übereinanderliegenden Stege jeweils ein Magnetfeld mit gleicher Umlaufrichtung erzeugen können.

Der in dem Durchbruch 43 der positiven Stromschiene 42 und/oder dem Durchbruch 44 der negativen Stromschiene 41 angeordnete Stromsensor 49 weist in diesem Ausführungsbeispiel zwei Hallsensoren 50 und 52 auf, und ist ausgebildet, in Abhängigkeit der von den Hallsensoren 50 und 51 erfassten Magnetfelder ein Stromsignal zu erzeugen, das den in den Stromschienen 41 und 42 fließenden Strom repräsentiert.

Figur 7 zeigt auch eine Variante zu der Stromerfassungsanordnung, bei der zusätzlich zu den in dem Durchbruch angeordneten Hallsensoren 50 und 51 auf den äußeren Seiten der Stege jeweils angeordnete Sensoren 56 und/oder 57 gebildet sein können, welche den in den Stromschienen 41 und 42 fließenden Strom zusätzlich oder redundant zu den Hallsensoren 50 und 51 erfassen können.

Die Stromschienen 41 und 42 können jeweils - wie gestrichelt angedeutet, entlang der Längserstreckung 52 eine Breite aufweisen, die der Summe der Stegbreiten der Stege 45 und 46 beziehungsweise 47 und 48 entspricht oder kleiner als die Summe der Stegbreiten ausgebildet ist, so dass auf dem Längsabschnitt 54 dieselbe Stromdichte gebildet sein kann wie auf den den Längsabschnitten umgebenden Bereichen der Stromschienen. Dadurch wird eine Hot-Spot-Bildung im Bereich der Längsabschnitts 54 der Stromerfassung vermieden.

Figur 8 zeigt eine Stromerfassungsanordnung 55 in einer Schnittdarstellung, welche die in Figur 7 gezeigten Komponenten umfasst, und zusätzlich dazu eine elektrisch isolierende Schicht 53, durch welche die Stromschienen 41 und 42 voneinander getrennt sind. Die Stromschienen 41 und 42 bilden zusammen mit der elektrisch isolierenden Schicht 53 einen Schaltungsträger. Die elektrisch isolierende Schicht 53 ist beispielsweise eine Keramikschicht, insbesondere Aluminiumoxidschicht oder Siliziumnitridschicht. Der Schaltungsträger ist beispielsweise ein AMB-Schaltungsträger (AMB = Active-Metal-Brazed), ein DCB-Schaltungsträger (DCB = Direct-Copper-Bonded), oder ein IMS-Schaltungsträger (IMS = Insulated-Metal-Substrate).

Die Stege 45 und 46 der positiven Stromschiene 42 liegen jeweils mit den Stegen 47 und 48 zueinander beabstandet derart voneinander elektrisch isoliert übereinander, dass die auf dem Längsabschnitt gebildeten Durchbrüche 43 und 44 der Stromschiene 42 beziehungsweise 43 miteinander fluchten und einen gemeinsamen Durchbruch zum Durchtritt der jeweils durch um die Stege ringförmig gebildeten Magnetfelder ausbilden.

Das Stegepaar, gebildet aus dem Steg 46 der positiven Stromschiene 42 und dem Steg 48 der negativen Stromschiene 41 erzeugt bei Stromdurchfluss das gleichgerichtete Magnetfeld 57, welches sich aus der Summe der einzelnen um die Stege gebildeten Magnetfelder als verstärktes Magnetfeld ausbilden kann. Das so durch Feldüberlagerung verstärkte Magnetfeld 57 kann von dem in dem Durchbruch angeordneten Stromsensor, und insbesondere dem Hallsensor 50 erfasst werden.

Das Stegpaar, gebildet aus dem Steg 45 der positiven Stromschiene 42 und dem Steg 47 der negativen Stromschiene 41 kann ein gleichgerichtetes durch Superposition verstärktes gemeinsames Magnetfeld 56 erzeugen, das den Durchbruch, gebildet aus den übereinanderliegenden Durchbrüchen 43 und 44 durchfluten kann und dort von dem Hallsensor 52 des Stromsensors 49 erfasst werden kann. Die Magnetfelder 56 und 57 durchfluten den Durchbruch in zueinander entgegengesetzten Richtungen.

Der Stromsensor 49 kann so aus den einzelnen Stromsignalen der Hallsensoren durch Differenzbildung der einzelnen Stromsignale ein Stromsignal erzeugen, das den in den Stegen fließenden Summenstrom repräsentiert.

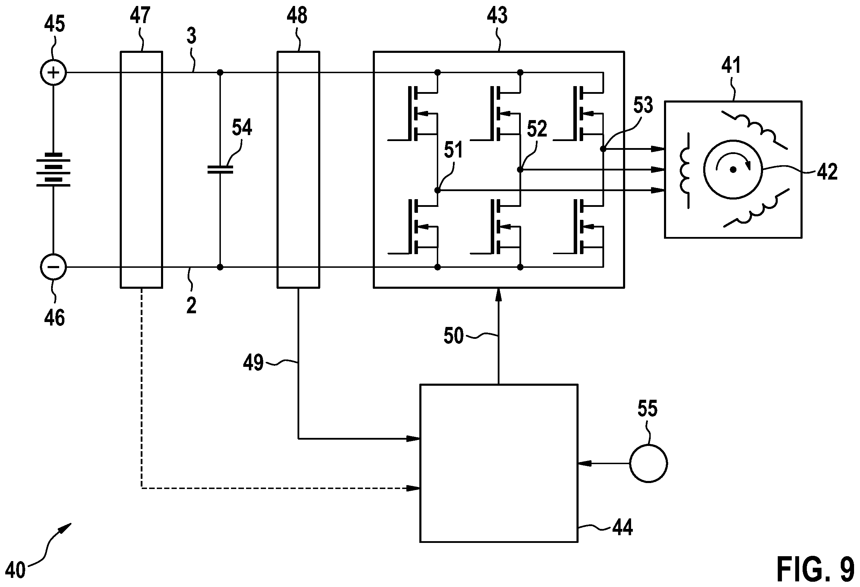

Figur 9 zeigt ein Ausführungsbeispiel für eine elektrische Maschine 40. Die elektrische Maschine 40 umfasst einen Stator 41, und einen insbesondere permanentmagnetisch ausgebildeten Rotor 42. Die elektrische Maschine 40 umfasst auch eine Leistungsendstufe 43, welche in diesem Ausführungsbeispiel als B6-Brücke ausgebildet ist. Die Leistungsendstufe 43 umfasst in diesem Ausführungsbeispiel für jede Phase der elektrischen Maschine 40 eine Halbleiterschalter-Halbbrücke. In diesem Ausführungsbeispiel umfasst die elektrische Maschine 40 drei Phasen, und somit auch drei Halbleiterschalter-Halbbrücken, welche jeweils mit einem Phasenausgang 51, 52 beziehungsweise 53 verbunden sind.

Die Leistungsendstufe 43 ist ausgangsseitig mit dem Stator 41, und dort mit Statorspulen des Stators 41 elektrisch verbunden. Die Leistungsendstufe 43 ist ausgebildet, den Stator 41 zum Erzeugen eines magnetischen Drehfeldes zum Drehbewegen des Rotors 42 zu bestromen. Die Leistungsendstufe 43 ist dazu mit einem positiven Stromversorgungsanschluss 45, und einem negativen Stromversorgungsanschluss 46 verbunden, und ausgebildet, aus einer von den Stromversorgungsanschlüssen 45 und 46 bereitgestellten Gleichspannung, einen Wechselstrom für jede Phase der elektrischen Maschine zum Erzeugen des magnetischen Drehfeldes zu erzeugen.

Die elektrische Maschine 40 umfasst auch eine Verarbeitungseinheit 44, welche beispielsweise durch einen Mikrocontroller, einen Mikroprozessor, oder ein ASIC (ASIC = Application-Specific-Integrated-Cicuit) gebildet sein kann. Die Verarbeitungseinheit 44 ist ausgangsseitig mittels einer Verbindungsleitung 50 mit der Leistungsendstufe 43 verbunden, und ausgebildet, die Halbleiterschalter der Halbleiterschalter-Halbbrücken der Leistungsendstufe 43, insbesondere pulsweitenmoduliert, zum Bestromen des Stators 41 anzusteuern.

Die Verarbeitungseinheit 44 ist in diesem Ausführungsbeispiel zur feldorientierten Regelung der elektrischen Maschine 40 ausgebildet. Die feldorientierte Regelung der Maschine 40 kann dazu in Abhängigkeit eines von einem Stromsensor 47, einem Stromsensor 48 oder in Abhängigkeit von beiden Stromsensoren 47 und 48 erfassten Stroms erfolgen. Die elektrische Maschine 40 umfasst einen Zwischenkreiskondensator 54. Der Zwischenkreiskondensator 54 ist zu dem positiven Stromversorgungsanschluss 45 und zu dem negativen Stromversorgungsanschluss 46 parallel geschaltet. Die Maschine 40 weist auch eine negative Stromschiene 2 auf, und eine positive Stromschiene 3, wobei die positive Stromschiene 3 die Leistungsendstufe 43 mit dem positiven Stromversorgungsanschluss 45 verbindet, und die negative Stromschiene 2 die Leistungsendstufe 43 mit dem negativen Stromversorgungsanschluss 46 verbindet.

Der Zwischenkreiskondensator 54 greift in diesem Ausführungsbeispiel die Versorgungsspannung auf einem Längsabschnitt der zueinander parallel geführten Stromschienen 2 und 3 ab. Auf dem sich zwischen dem Stromversorgungsanschluss 45 beziehungsweise 46 und dem Zwischenkreiskondensator 45 erstreckenden Längsabschnitt ist der Stromsensor 47 angeordnet. Der Stromsensor 47 ist beispielsweise - wie in Figur 1 dargestellt - durch die U-förmigen Mäander 4 und 5 gebildet und umfasst die Hall-Stromsensoren 7 und 8. Der Stromsensor 47 kann - gemeinsam mit den Stromschienen 2 und 3 - auf einem sich zwischen dem Zwischenkreiskondensator 54 und den Stromversorgungsanschlüssen 45 und 46 erstreckenden Längsabschnitt der Stromschienen 2 und 3 die Stromerfassungsanordnung 1 gemäß Figur 1 ausbilden.

Der Stromsensor 48 ist auf einem sich zwischen dem Zwischenkreiskondensator 54 und der Leistungsendstufe 43 erstreckende Längsabschnitt der Stromschienen 2 und 3 ausgebildet, und kann den zwischen dem Zwischenkreiskondensator 54 und der Leistungsendstufe 43 fließenden Strom erfassen. Der zwischen dem Zwischenkreiskondensator 54 und der Leistungsendstufe 43 fließende Strom kann durch die pulsweitenmodulierte Ansteuerung der Leistungsendstufe, bewirkt durch die Verarbeitungseinheit 44, gestuft ausgebildet sein.

Die Verarbeitungseinheit 44 ist ausgebildet, die Leistungsendstufe 43 zum Erzeugen des Maschinenstromes in Abhängigkeit des von dem Stromsensor 47, und/oder von dem Stromsensor 48 erfassten Versorgungsstroms beziehungsweise Zwischenkreisstroms anzusteuern. Die Verarbeitungseinheit 44 kann dazu einen Soll-Strom, repräsentiert durch ein an einem Eingang 55 der Verarbeitungseinheit 44 empfangenen Drehmomentvorgabesignals, in Abhängigkeit des erfassten Zwischenkreisstromes, erfasst durch den Sensor 48, oder eines von der Maschine 40 aufgenommenen Gesamtstromes, erfasst durch den Stromsensor 47, oder in Abhängigkeit beider Ströme regeln.

Der Stromsensor 47 kann - anders als zuvor beschrieben - gemäß der Stromerfassungsanordnung 10 wie in den Figuren 2 und 3 dargestellt, oder gemäß der Stromerfassungsanordnung 22, wie in den Figuren 4 und 5 dargestellt, oder gemäß der Stromerfassungsanordnung 33, wie in Figur 6 dargestellt, ausgebildet sein. Der Stromsensor 48 kann, anders als zuvor beschrieben, gemäß der in den Figuren 2 und 3 dargestellten Stromerfassungsanordnung 10, oder gemäß der in den Figuren 4 und 5 dargestellten Stromerfassungsanordnung 22, oder gemäß der in Figur 6 dargestellten Stromerfassungsanordnung 33 ausgebildet sein. Die Stromsensoren 47 und 48 können jeweils die Stromerfassungsanordnung 1 gemäß Figur 1, die Stromerfassungsanordnung 10 gemäß den Figuren 2 und 3, die Stromerfassungsanordnung 22 gemäß den Figuren 4 und 5, oder die Stromerfassungsanordnung 33 gemäß Figur 6 ausbilden.

Die Verarbeitungseinheit 44 der elektrischen Maschine 40 kann beispielsweise die feldorientierte Regelung der Maschine 40 gemäß der in der DE 10 2011 076 709 A1, oder gemäß der in der DE 10 2008 04 2978 A1 beschriebenen Art durchführen.

Die in Figur 9 beschriebene elektrische Maschine kann beispielsweise Bestandteil eines elektrischen Kompressors, Bestandteil eines Elektrofahrrads, eine Antriebsmaschine eines Elektrofahrzeugs, eine Antriebsmaschine eines Elektrorollers, auch E-Scooter genannt, sein.

## Patentansprüche

1. Stromerfassungsanordnung (1, 10, 22, 33, 47, 48),
wobei die Stromerfassungsanordnung (1, 10, 22, 33, 47, 48) wenigstens eine elektrisch leitfähige Stromschiene (2, 3, 11, 12, 23, 24, 36, 37) aufweist, und die elektrisch leitfähige Stromschiene (2, 3, 11, 12, 23, 24, 36, 37) zum Führen eines Laststromes ausgebildet ist, wobei in der Stromschiene (2, 3, 11, 12, 23, 24, 36, 37) ein Längsabschnitt (61) zum Erfassen des in der Stromschiene (2, 3, 11, 12, 23, 24, 36, 37) fließenden Laststromes ausgebildet ist, und die Stromerfassungsanordnung (1, 10, 22, 33) wenigstens einen Stromsensor (7, 8, 9, 16, 17, 18, 30, 31, 34, 35) aufweist, welcher angeordnet und ausgebildet ist, ein auf dem Längsabschnitt (61) erzeugtes Magnetfeld (20, 21) zu erfassen, und in Abhängigkeit des Magnetfelds (20, 21) ein den Laststrom repräsentierendes Stromsignal zu erzeugen, wobei die Stromerfassungsanordnung (1, 10, 22, 33, 47, 48) eine weitere Stromschiene (2, 3, 11, 12, 23, 24, 36, 37) aufweist, welche ausgebildet ist, einen Strom mit einer zu dem Laststrom entgegengesetzten Stromrichtung zu führen,
und die zu der Stromschiene (2, 3, 11, 12, 23, 24, 36, 37) parallel verlaufende weitere Stromschiene (2, 3, 11, 12, 23, 24, 36, 37) im Bereich des Längsabschnitts (61) zu der Stromschiene (2, 3, 11, 12, 23, 24, 36, 37) derart geführt ist, dass ein auf dem Längsabschnitt (61) der weiteren Stromschiene erzeugtes Magnetfeld (20) das Magnetfeld (21) der Stromschiene (2, 3, 11, 12, 23, 24, 36, 37) feldverstärkend überlagern kann, wobei die weitere Stromschiene (2, 3, 11, 12, 23, 24, 36, 37) ausgebildet ist, insbesondere mittels Feld- und/oder Störungskompensation gemeinsam mit der Stromschiene (2, 3, 11, 12, 23, 24, 36, 37) eine niederinduktive Anordnung auszubilden, indem die Stromschiene und die weitere Stromschiene längserstreckt ausgebildet sind und dabei entlang einer Längserstreckung übereinanderliegend angeordnet sind, und
wobei die Stromschiene (2, 3, 11, 12, 23, 24, 36, 37) und die weitere Stromschiene (2, 3, 11, 12, 23, 24, 36, 37) im Bereich des Längsabschnitts (61) jeweils eine Aussparung (27, 43, 44) aufweisen, die in einer Orthogonalprojektion einander überlappend einen Durchbruch zum Durchtritt eines gemeinsamen überlagernden Magnetfeldes ausbilden, wobei der Stromsensor (30, 31, 50, 51) im Bereich der Öffnung derart angeordnet ist, dass der Stromsensor (30, 31, 50, 51) von dem Durchbruch (27) umgebenden Stromschienenabschnitten (28, 29) erzeugte Magnetfelder erfassen kann.

2. Stromerfassungsanordnung nach Anspruch 1,
**dadurch gekennzeichnet, dass**
die Stromschiene (2, 3, 11, 12, 23, 24, 36, 37) zum Führen eines positiven Stromversorgungspotentials ausgebildet ist, und die weitere Stromschiene (2, 3, 11, 12, 23, 24, 36, 37) zum Führen eines negativen Stromversorgungspotentials ausgebildet ist.

3. Stromerfassungsanordnung (1, 10, 22, 33, 47, 48) nach Anspruch 1 oder 2,
**dadurch gekennzeichnet, dass**
die Stromschiene (2, 3, 11, 12, 23, 24, 36, 37) und die weitere Stromschiene (2, 3, 11, 12, 23, 24, 36, 37) im Bereich des Längsabschnitts (61) jeweils derart mäanderförmig zueinander geführt sind, dass in der Stromschiene (2, 3, 11, 12, 23, 24, 36, 37) und der weiteren Stromschiene (2, 3, 11, 12, 23, 24, 36, 37) einander entgegengesetzt fließende Ströme auf dem Längsabschnitt (61) jeweils mit wenigstens einer Richtungskomponente in die gleiche Richtung oder vollständig in die gleiche Richtung fließen können.

4. Stromerfassungsanordnung (1, 10, 22, 33, 47, 48) nach Anspruch 3,
**dadurch gekennzeichnet, dass**
die Stromschiene (2, 3, 11, 12, 23, 24, 36, 37) und die weitere Stromschiene (2, 3, 11, 12, 23, 24, 36, 37) auf dem Längsabschnitt (61) jeweils zueinander gegensinnig S-förmig, oder zueinander symmetrisch, insbesondere achsensymmetrisch oder punktsymmetrisch S-förmig gebildet sind.

5. Stromerfassungsanordnung (1, 10, 22, 33, 47, 48) nach einem der vorhergehenden Ansprüche,
**dadurch gekennzeichnet, dass**
die weitere Stromschiene (2, 3, 11, 12, 23, 24, 36, 37) im Bereich des Längsabschnitts (61) schmaler ausgebildet ist als auf den den Längsabschnitt (61) umgebenden Bereichen.

6. Stromerfassungsanordnung (1, 10, 22, 33, 47, 48) nach einem der vorhergehenden Ansprüche,
**dadurch gekennzeichnet, dass**
die Stromschiene (2, 3, 11, 12, 23, 24, 36, 37) und die weitere Stromschiene (2, 3, 11, 12, 23, 24, 36, 37) auf dem Längsabschnitt (61) jeweils U-förmig (4, 5) gebildet sind, wobei die U-Öffnungen in zueinander entgegengesetzte Richtungen weisen.

7. Stromerfassungsanordnung (1, 10, 22, 33, 47, 48) nach einem der vorhergehenden Ansprüche,
**dadurch gekennzeichnet, dass**
die Stromschiene (2, 3, 11, 12, 23, 24, 36, 37) und die weitere Stromschiene (2, 3, 11, 12, 23, 24, 36, 37) auf dem Längsabschnitt jeweils in zueinander entgegengesetzt weisende, quer zur Längserstreckung der Leiterbahn gebildete Aussparungen (13, 14) aufweist.

8. Stromerfassungsanordnung (1, 10, 22, 33, 47, 48) nach einem der vorhergehenden Ansprüche,
**dadurch gekennzeichnet, dass**
die Stromerfassungsanordnung einen Schaltungsträger (19, 32, 26, 28, 29) umfasst, und der Schaltungsträger (19, 32, 26, 28, 29) eine elektrisch isolierende Schicht (19, 32), insbesondere Keramikschicht aufweist, und die Stromschienen (2, 3, 11, 12, 23, 24, 36, 37) jeweils durch eine elektrisch leitfähige Schicht des Schaltungsträgers gebildet sind, die durch die elektrisch isolierende Schicht (19, 32) voneinander isoliert und getrennt sind.

9. Stromerfassungsanordnung (1, 10, 22, 33, 47, 48) nach Anspruch 8,
**dadurch gekennzeichnet, dass**
der Schaltungsträger (19, 32, 26, 28, 29) zum Kontaktieren einer Wärmesenke ausgebildet ist und eine elektrisch leitfähige Rückseitenschicht aufweist, welche zum Kontaktieren einer Wärmesenke ausgebildet ist, wobei die weitere Stromschiene (2, 11, 23, 36) eine elektrisch leitfähige und wärmeleitfähige Rückseitenschicht des Schaltungsträgers (19, 32, 26, 28, 29) bildet.

10. Stromerfassungsanordnung (1, 10, 22, 33, 47, 48) nach einem der vorhergehenden Ansprüche,
**dadurch gekennzeichnet, dass**
der Stromsensor ein differenziell erfassender Stromsensor ist und einen ersten und einen zweiten Hallsensor umfasst, wobei ein Hallsensor im Bereich der Öffnung angeordnet ist.

11. Stromerfassungsanordnung (1, 10, 22, 33, 47, 48) nach Anspruch 10,
**dadurch gekennzeichnet, dass**
der Stromsensor einen dritten Hallsensor umfasst.

12. Elektrische Maschine (40) mit einer Stromerfassungsanordnung (1, 10, 22, 33, 47, 48) nach einem der vorhergehenden Ansprüche,
wobei die Stromerfassungsanordnung (1, 10, 22, 33, 47, 48) ausgebildet ist, einen Versorgungsstrom der Maschine und/oder einen Zwischenkreisstrom zu erfassen, wobei die Maschine zur Stromversorgung zwei zueinander parallel und niederinduktiv geführte Stromschienen (2, 3, 11, 12, 23, 24, 36, 37) aufweist, wobei der Stromsensor im Bereich der Stromschienen (2, 3, 11, 12, 23, 24, 36, 37) angeordnet und ausgebildet ist, den auf den Stromschienen (2, 3, 11, 12, 23, 24, 36, 37) fließenden Strom, insbesondere Gleichstrom zu erfassen und ein den erfassten Strom repräsentierendes Stromsignal zu erzeugen, wobei die Maschine eine Steuereinheit (44) aufweist, welche ausgebildet ist, die Maschine in Abhängigkeit des Stromsignals und insbesondere so in Abhängigkeit erfassten Versorgungsstroms und/oder Zwischenkreisstroms anzusteuern.

## Claims

1. Current detecting arrangement (1, 10, 22, 33, 47, 48),
wherein the current detecting arrangement (1, 10, 22, 33, 47, 48) has at least one electrically conductive busbar (2, 3, 11, 12, 23, 24, 36, 37), and the electrically conductive busbar (2, 3, 11, 12, 23, 24, 36, 37) is designed to conduct a load current, wherein a longitudinal section (61) for detecting the load current flowing through the busbar (2, 3, 11, 12, 23, 24, 36, 37) is formed in the busbar (2, 3, 11, 12, 23, 24, 36, 37), and the current detecting arrangement (1, 10, 22, 33) has at least one current sensor (7, 8, 9, 16, 17, 18, 30, 31, 34, 35) which is arranged and designed to detect a magnetic field (20, 21) generated on the longitudinal section (61) and to generate, depending on the magnetic field (20, 21), a current signal representing the load current, wherein the current detecting arrangement (1, 10, 22, 33, 47, 48) has a further busbar (2, 3, 11, 12, 23, 24, 36, 37), which is designed to conduct a current in a current direction opposite to the load current,
and the further busbar (2, 3, 11, 12, 23, 24, 36, 37) running parallel to the busbar (2, 3, 11, 12, 23, 24, 36, 37) in the region of the longitudinal section (61) is led to the busbar (2, 3, 11, 12, 23, 24, 36, 37) in such a way that a magnetic field (20) generated on the longitudinal section (61) of the further busbar can be superimposed on the magnetic field (21) of the busbar (2, 3, 11, 12, 23, 24, 36, 37) in a field-reinforcing manner, wherein the further busbar (2, 3, 11, 12, 23, 24, 36, 37) is designed to form, in particular by means of field and/or interference compensation, a low-inductance arrangement together with the busbar (2, 3, 11, 12, 23, 24, 36, 37) owing to the fact that the busbar and the further busbar are designed to extend lengthways while being arranged one on top of another along a longitudinal extension, and
wherein the busbar (2, 3, 11, 12, 23, 24, 36, 37) and the further busbar (2, 3, 11, 12, 23, 24, 36, 37) in the region of the longitudinal section (61) each have a recess (27, 43, 44) which, overlapping one another in an orthogonal projection, form a through-hole for allowing a common superimposed magnetic field to pass through, wherein the current sensor (30, 31, 50, 51) is arranged in the region of the opening in such a way that the current sensor (30, 31, 50, 51) can detect magnetic fields generated by busbar sections (28, 29) surrounding the through-hole (27).

2. Current detecting arrangement according to Claim 1,
**characterized in that**
the busbar (2, 3, 11, 12, 23, 24, 36, 37) is designed to conduct a positive current supply potential, and the further busbar (2, 3, 11, 12, 23, 24, 36, 37) is designed to conduct a negative current supply potential.

3. Current detecting arrangement (1, 10, 22, 33, 47, 48) according to Claim 1 or 2, **characterized in that**
the busbar (2, 3, 11, 12, 23, 24, 36, 37) and the further busbar (2, 3, 11, 12, 23, 24, 36, 37) in the region of the longitudinal section (61) are each led to one another in a meandering manner in such a way that currents flowing through the busbar (2, 3, 11, 12, 23, 24, 36, 37) and the further busbar (2, 3, 11, 12, 23, 24, 36, 37) in opposite directions to one another on the longitudinal section (61) can each flow with at least one directional component in the same direction, or can each flow completely in the same direction.

4. Current detecting arrangement (1, 10, 22, 33, 47, 48) according to Claim 3, **characterized in that**
the busbar (2, 3, 11, 12, 23, 24, 36, 37) and the further busbar (2, 3, 11, 12, 23, 24, 36, 37) on the longitudinal section (61) are each formed in an S-shape in opposite directions to one another, or symmetrically to one another, in particular axially symmetrically or point symmetrically in an S-shape.

5. Current detecting arrangement (1, 10, 22, 33, 47, 48) according to one of the preceding claims,
**characterized in that**
the further busbar (2, 3, 11, 12, 23, 24, 36, 37) is designed to be narrower in the region of the longitudinal section (61) than on the regions surrounding the longitudinal section (61).

6. Current detecting arrangement (1, 10, 22, 33, 47, 48) according to one of the preceding claims,
**characterized in that**
the busbar (2, 3, 11, 12, 23, 24, 36, 37) and the further busbar (2, 3, 11, 12, 23, 24, 36, 37) on the longitudinal section (61) are each formed in a U-shape (4, 5), wherein the U-openings point in opposite directions to one another.

7. Current detecting arrangement (1, 10, 22, 33, 47, 48) according to one of the preceding claims,
**characterized in that**
the busbar (2, 3, 11, 12, 23, 24, 36, 37) and the further busbar (2, 3, 11, 12, 23, 24, 36, 37) on the longitudinal section each have recesses (13, 14) formed pointing in opposite directions to one another, transversely to the longitudinal extension of the conductor track.

8. Current detecting arrangement (1, 10, 22, 33, 47, 48) according to one of the preceding claims,
**characterized in that**
the current detecting arrangement comprises a circuit carrier (19, 32, 26, 28, 29), and the circuit carrier (19, 32, 26, 28, 29) has an electrically insulating layer (19, 32), in particular ceramic layer, and the busbars (2, 3, 11, 12, 23, 24, 36, 37) are each formed by an electrically conductive layer of the circuit carrier, which are insulated and separated from one another by the electrically insulating layer (19, 32).

9. Current detecting arrangement (1, 10, 22, 33, 47, 48) according to Claim 8, **characterized in that**
the circuit carrier (19, 32, 26, 28, 29) is designed to make contact with a heat sink and has an electrically conductive rear-side layer which is designed to make contact with a heat sink, wherein the further busbar (2, 11, 23, 36) forms an electrically conductive and thermally conductive rear-side layer of the circuit carrier (19, 32, 26, 28, 29).

10. Current detecting arrangement (1, 10, 22, 33, 47, 48) according to one of the preceding claims,
**characterized in that**
the current sensor is a differential current sensor and comprises a first and a second Hall sensor, wherein a Hall sensor is arranged in the region of the opening.

11. Current detecting arrangement (1, 10, 22, 33, 47, 48) according to Claim 10, **characterized in that**
the current sensor comprises a third Hall sensor.

12. Electric machine (40) having a current detecting arrangement (1, 10, 22, 33, 47, 48) according to one of the preceding claims,
wherein the current detecting arrangement (1, 10, 22, 33, 47, 48) is designed to detect a supply current of the machine and/or a DC-link current, wherein the machine, for the current supply, has two busbars (2, 3, 11, 12, 23, 24, 36, 37) which are led parallel to one another and with low inductance, wherein the current sensor in the region of the busbars (2, 3, 11, 12, 23, 24, 36, 37) is arranged and designed to detect the current, in particular DC current, flowing on the busbars (2, 3, 11, 12, 23, 24, 36, 37) and to generate a current signal representing the detected current, wherein the machine has a control unit (44) which is designed to control the machine in dependence on the current signal and in particular thus in dependence on detected supply current and/or DC-link current.

## Revendications

1. Ensemble de détection de courant (1, 10, 22, 33, 47, 48),
l'ensemble de détection de courant (1, 10, 22, 33, 47, 48) comportant au moins une barre omnibus électroconductrice (2, 3, 11, 12, 23, 24, 36, 37), et la barre omnibus électroconductrice (2, 3, 11, 12, 23, 24, 36, 37) étant formée pour guider un courant de charge, une section longitudinale (61) destinée à détecter le courant de charge circulant dans la barre omnibus (2, 3, 11, 12, 23, 24, 36, 37) étant formée dans la barre omnibus (2, 3, 11, 12, 23, 24, 36, 37), et l'ensemble de détection de courant (1, 10, 22, 33) comportant au moins un capteur de courant (7, 8, 9, 16, 17, 18, 30, 31, 34, 35), qui est disposé et formé pour détecter un champ magnétique (20, 21) généré sur la section longitudinale (61) et pour générer un signal de courant représentant le courant de charge en fonction du champ magnétique (20, 21), l'ensemble de détection de courant (1, 10, 22, 33, 47, 48) comportant une autre barre omnibus (2, 3, 11, 12, 23, 24, 36, 37), qui est formée pour guider un courant avec une direction de courant opposée au courant de charge,
et l'autre barre omnibus (2, 3, 11, 12, 23, 24, 36, 37) s'étendant parallèlement à la barre omnibus (2, 3, 11, 12, 23, 24, 36, 37) étant guidée dans la zone de la section longitudinale (61) par rapport à la barre omnibus (2, 3, 11, 12, 23, 24, 36, 37) de telle manière qu'un champ magnétique (20) généré sur la section longitudinale (61) de l'autre barre omnibus peut se superposer au champ magnétique (21) de la barre omnibus (2, 3, 11, 12, 23, 24, 36, 37) en amplifiant le champ, l'autre barre omnibus (2, 3, 11, 12, 23, 24, 36, 37) étant formée pour former, en particulier par compensation de champ et/ou de dysfonctionnement conjointement avec la barre omnibus (2, 3, 11, 12, 23, 24, 36, 37) un ensemble à faible inductance en ce que la barre omnibus et l'autre barre omnibus sont formées de manière à s'étendre longitudinalement et sont disposées l'une au-dessus de l'autre le long d'une extension longitudinale, et la barre omnibus (2, 3, 11, 12, 23, 24, 36, 37) et l'autre barre omnibus (2, 3, 11, 12, 23, 24, 36, 37) comportant dans la zone de la section longitudinale (61) chacune un évidement (27, 43, 44) qui, par superposition l'un avec l'autre dans une projection orthogonale, forment un ajour pour le passage d'un champ magnétique commun superposé, le capteur de courant (30, 31, 50, 51) étant disposé dans la zone de l'ouverture de telle manière que le capteur de courant (30, 31, 50, 51) peut détecter des champs magnétiques générés par des sections (28, 29) de barre omnibus entourant l'ajour (27).

2. Ensemble de détection de courant selon la revendication 1,
**caractérisé en ce que**
la barre omnibus (2, 3, 11, 12, 23, 24, 36, 37) est formée pour guider un potentiel d'alimentation en courant positif, et l'autre barre omnibus (2, 3, 11, 12, 23, 24, 36, 37) est formée pour guider un potentiel d'alimentation en courant négatif.

3. Ensemble de détection de courant (1, 10, 22, 33, 47, 48) selon la revendication 1 ou 2, **caractérisé en ce que**
la barre omnibus (2, 3, 11, 12, 23, 24, 36, 37) et l'autre barre omnibus (2, 3, 11, 12, 23, 24, 36, 37) dans la zone de la section longitudinale (61) sont guidées chacune l'une par rapport à l'autre en méandres de telle manière que, dans la barre omnibus (2, 3, 11, 12, 23, 24, 36, 37) et l'autre barre omnibus (2, 3, 11, 12, 23, 24, 36, 37), des courants circulant à l'opposé les uns des autres peuvent circuler dans la même direction ou totalement dans la même direction chacun avec au moins une composante directionnelle sur la section longitudinale (61).

4. Ensemble de détection de courant (1, 10, 22, 33, 47, 48) selon la revendication 3,
**caractérisé en ce que**
la barre omnibus (2, 3, 11, 12, 23, 24, 36, 37) et l'autre barre omnibus (2, 3, 11, 12, 23, 24, 36, 37) sont formées sur la section longitudinale (61) chacune en forme de S dans des directions opposées ou en forme de S de manière symétrique l'une par rapport à l'autre, en particulier de manière symétrique axialement ou en symétrie ponctuelle.

5. Ensemble de détection de courant (1, 10, 22, 33, 47, 48) selon l'une des revendications précédentes,
**caractérisé en ce que**
l'autre barre omnibus (2, 3, 11, 12, 23, 24, 36, 37) est plus étroite dans la zone de la section longitudinale (61) que sur les zones entourant la section longitudinale (61).

6. Ensemble de détection de courant (1, 10, 22, 33, 47, 48) selon l'une des revendications précédentes,
**caractérisé en ce que**
la barre omnibus (2, 3, 11, 12, 23, 24, 36, 37) et l'autre barre omnibus (2, 3, 11, 12, 23, 24, 36, 37) sont formées chacune en forme de U (4, 5) sur la section longitudinale (61), les ouvertures en U pointant dans des directions opposées les unes aux autres.

7. Ensemble de détection de courant (1, 10, 22, 33, 47, 48) selon l'une des revendications précédentes,
**caractérisé en ce que**
la barre omnibus (2, 3, 11, 12, 23, 24, 36, 37) et l'autre barre omnibus (2, 3, 11, 12, 23, 24, 36, 37) comportent sur la section longitudinale des évidements (13, 14) pointant respectivement dans des directions opposées les uns par rapport aux autres, formés transversalement par rapport à l'extension longitudinale de la piste conductrice.

8. Ensemble de détection de courant (1, 10, 22, 33, 47, 48) selon l'une des revendications précédentes,
**caractérisé en ce que**
l'ensemble de détection de courant comprend un support de circuit (19, 32, 26, 28, 29), et le support de circuit (19, 32, 26, 28, 29) comporte une couche électriquement isolante (19, 32), en particulier une couche céramique, et les barres omnibus (2, 3, 11, 12, 23, 24, 36, 37) sont formées chacune par une couche électriquement conductrice du support de circuit, qui sont isolées l'une de l'autre et séparées l'une de l'autre par la couche électriquement isolante (19, 32).

9. Ensemble de détection de courant (1, 10, 22, 33, 47, 48) selon la revendication 8,
**caractérisé en ce que**
le support de circuit (19, 32, 26, 28, 29) est formé pour entrer en contact avec un dissipateur thermique et comporte une couche arrière électroconductrice, qui est formée pour entrer en contact avec un dissipateur thermique, l'autre barre omnibus (2, 11, 23, 36) formant une couche arrière électroconductrice et thermoconductrice du support de circuit (19, 32, 26, 28, 29).

10. Ensemble de détection de courant (1, 10, 22, 33, 47, 48) selon l'une des revendications précédentes,
**caractérisé en ce que**
le capteur de courant est un capteur de courant à détection différentielle et comprend un premier et un deuxième capteur à effet Hall, un capteur à effet Hall étant disposé dans la zone de l'ouverture.

11. Ensemble de détection de courant (1, 10, 22, 33, 47, 48) selon la revendication 10,
**caractérisé en ce que**
le capteur de courant comprend un troisième capteur à effet Hall.

12. Machine électrique (40) avec un ensemble de détection de courant (1, 10, 22, 33, 47, 48) selon l'une des revendications précédentes,
l'ensemble de détection de courant (1, 10, 22, 33, 47, 48) étant formé pour détecter un courant d'alimentation de la machine et/ou un courant de circuit intermédiaire, la machine d'alimentation en courant comportant deux barres omnibus (2, 3, 11, 12, 23, 24, 36, 37) guidées parallèlement l'une à l'autre et avec une faible inductance, le capteur de courant étant disposé dans la zone des barres omnibus (2, 3, 11, 12, 23, 24, 36, 37) et étant formé pour détecter le courant circulant sur les barres omnibus (2, 3, 11, 12, 23, 24, 36, 37), en particulier le courant continu et pour générer un signal de courant représentant le courant détecté, la machine comportant une unité de commande (44) qui est formée pour piloter la machine en fonction du signal de courant et en particulier ainsi en fonction du courant d'alimentation détecté et/ou du courant de circuit intermédiaire.
